# DEMANDE DE BREVET EUROPEEN

(11) **EP 4 357 324 A1**
(43) Date de publication de la demande: **24.04.2024**
(21) Numéro de dépôt: 23204148.3
(22) Date de dépôt: 17.10.2023
(51) Int. Cl.: C06B 21/00, C06B 23/00

(54) **PROCEDE DE FABRICATION D'UNE COMPOSITION EXPLOSIVE FUSIBLE/COULABLE**

(30) Priorité: 20.10.2022 FR 2210862
(71) Demandeur: THALES, 92190 Meudon (FR)
(72) Inventeur: GILLOUX, Teddy, 45240 LA FERTE SAINT AUBIN (FR); BULOT, Stéphane, 45240 LA FERTE SAINT AUBIN (FR)
(74) Mandataire: Atout PI Laplace

(57) **Abrégé**

Procédé de fabrication d'une composition explosive fusible/coulable comprenant les étapes suivantes :
- fonte d'un explosif fusible comprenant un cycle aromatique nitré, et préférentiellement du 2,4,6-trinitrotoluène ;
- ajout (2) de modifiant de viscosité dans l'explosif fusible fondu, le modifiant de viscosité ayant une solubilité dans l'explosif fusible, supérieure à un seuil de solubilité (Ss) au-dessus d'une température de seuil (Ts), et inférieure au seuil de solubilité (Ss) au-dessous de la température de seuil (Ts), la température de seuil (Ts) étant inférieure à une température (Tmc) de mélange et de chargement de la composition explosive, la viscosité de la composition étant inférieure à un seuil de viscosité (Vs) au-dessus de la température de seuil (Ts) et supérieure au seuil de viscosité (Vs) au-dessous de de la température de seuil (Ts) ; le modifiant de viscosité étant tel que pour une variation de température d'au plus 5°C en valeur absolue autour de la température de seuil, la variation correspondante de viscosité en valeur absolue est supérieure à 10 Pa.s fois la variation de température en valeur absolue, et la variation correspondante de solubilité en valeur absolue est supérieure à 15% massique.
- ajout d'au moins une espèce granulaire inerte et/ou au moins une espèce granulaire énergétique ;
les proportions des composants utilisés étant tels que de la composition obtenue comprend 20 à 60% massique d'explosif fusible, et au plus 10% massique de modifiant de viscosité, et préférentiellement 3 à 5 % de modifiant de viscosité.

## Description

L'invention porte sur un procédé de fabrication d'une composition explosive fusible/coulable, et son chargement dans une munition.

Ces chargements sont en grande majorité à base de 2,4,6-trinitrotoluène, d'acronyme TNT; un explosif qui a la particularité de fondre à des températures proches de 80°C permettant ainsi le chargement à l'état liquide d'une enveloppe métallique, tel un corps de munition, par la seule action de la gravité.

Il est usuel d'ajouter à cet explosif d'autres explosifs tels que l'hexogène (RDX), l'octogène (HMX) ou l'oxynitrotriazole (ONTA) ou encore des additifs (flegmatisants, stabilisants, sensibilisants, ... ) afin d'obtenir une formulation répondant aux exigences de la munition (performances détoniques, insensibilité, etc.).

Les formulations à fortes valeurs ajoutées intègrent souvent cinq à sept constituants. Elles sont par nature hétérogènes car différentes espèces granulaires se retrouvent dispersées aléatoirement dans un média fusible. Néanmoins, il est indispensable d'assurer la meilleure homogénéité possible du chargement explosif après solidification dans l'enveloppe de la munition afin de fiabiliser la sécurité et les performances des munitions pendant tout leur profil de vie (production, stockage, transport, utilisation et démilitarisation). Les paramètres couramment utilisés pour assurer cette homogénéité comprennent l'augmentation de la viscosité et la répartition granulométriques des additifs.

En effet, les espèces granulaires présentes dans un mélange très visqueux n'ont quasiment pas la possibilité de migrer (sédimentation ou crémage), limitant ainsi très significativement les risques d'inhomogénéité du chargement. Cependant la mise en oeuvre de chargements visqueux demande l'utilisation de technologies complexes, limitant entre autre les cadences de production.

Ces formulations doivent également répondre à des exigences de plus en plus sévères (faible dispersion des propriétés et conservation de ces propriétés après vieillissement), décrites pour la France dans l'instruction générale S-CAT 17500 édition 6 datée de décembre 2019, et pour les membres de l'OTAN au STANAG.4170 édition 3 daté de 2008. Se conformer à ces exigences réglementaires nécessite une maîtrise accrue de l'homogénéité de chargement d'une munition.

La criticité de la problématique liée à l'homogénéité du chargement explosif dans la munition est assez récente et suit l'évolution des critères associés à la sécurité d'utilisation et de stockage des munitions. Le maintien de cette homogénéité sur les formulations à plus de trois ingrédients granulaires est d'autant plus critique.

Historiquement, les munitions étaient chargées à base d'acide picrique puis de trinitrotoluène après la deuxième guerre mondiale. Ces chargements étaient mono-composants, ils répondaient donc de fait à cette problématique. Pour des raisons liées à l'augmentation des performances terminales des munitions, de nombreuses formulations ont été mises au point en ajoutant des additifs à cette base TNT.

Il a été intégré dans les formulations historiques des explosifs granulaires, comme le RDX et l'HMX, afin d'augmenter très significativement les performances en détonique, afin d'obtenir les performances souhaitées, ainsi que pour maintenir une homogénéité pendant tout le cycle de vie du produit. Notamment, un taux de l'ordre de 60% en masse d'espèce solide a été introduit (Composition B 60/40). Ce taux permet d'augmenter significativement la viscosité du mélange liquide pour limiter les déphasages et sédimentations, mais permet également de jouer sur la compacité des espèces. Le principe consiste à déterminer le plus précisément possible la répartition granulométrique permettant d'introduire le maximum d'espèces granulaires dans un espace donné. Cela a pour effet principal de bloquer l'arrangement des espèces les unes par rapport aux autres.

Cette très forte augmentation du pourcentage de constituants solides (au-delà des 60 % en masse) et cette modulation de la répartition granulométrique de chacun des additifs solides permet d'atteindre le maximum de compacité. Une fois que cette compacité est atteinte, les différentes espèces granulaires sont contraintes mécaniquement à ne pas sédimenter ou déphaser une fois chargées dans la munition. Néanmoins, en atteignant cette compacité, le mélange devient extrêmement visqueux dans la cuve et entraîne une limitation de la coulabilité de la formulation. Il est alors souvent nécessaire d'augmenter la température du mélange, voire de générer une dépression dans les enveloppes de munition (vide de l'ordre de 50 mbar). L'augmentation de la température entraîne une augmentation significative des dépenses d'énergie pour produire une munition, et la mise sous vide de l'opération de chargement n'est pas compatible des outils standards de l'homme de métier.

Il a été utilisé des additifs de type tensioactif afin d'assurer l'homogénéité et la stabilité dans le temps de la composition. Ces molécules ont la capacité de posséder une tête hydrophile et une queue hydrophobe permettant d'augmenter ainsi l'affinité entre le TNT et les flegmatisants. Nous pouvons citer les compositions brevetées XF13333 et XF11585 de NEXTER mentionnées dans les brevets FR2750131 et FR2954308 utilisant des tensioactifs de la famille des polyvinylpyrrolidone. Ces compositions ont fait l'objet d'un travail de thèse intitulé "Rhéologie des suspensions concentrées de matériaux énergétiques recyclables -Modélisation du temps de coulée". Un rapport technique WL-TR-94-7058 étudie l'impact et l'affinité chimique entre différentes familles de flegmatisants et le TNT dans l'objectif est de remplacer la composition D-2 (MIL-C-18164A) présent dans la formulation H-6 (compB/AI/ D-2) et le Destex (TNT/AI/ D-3). Dans ces cas, l'utilisation de lécithine de soja ainsi que de noir de charbon conduisait à stabiliser le mélange.

Ajouter un additif dans la formulation a pour objectif d'augmenter très fortement la viscosité du mélange tout en conservant une proportion de phase liquide supérieure à 50 %. De telles viscosités dans la cuve de mélange demandent des outils spécifiques pour assurer une homogénéisation des constituants tels que des pales d'agitation similaires à des crochets, pales en Z ou planétaires à feuillets. Ces moyens d'agitation ne sont alors plus adaptés aux formulations historiques et demandent aux industriels de mettre en place des outils dédiés à chaque formulation.

Il est proposé, selon un aspect de l'invention, un procédé de fabrication d'une composition explosive fusible/coulable comprenant les étapes suivantes :
- fonte d'un explosif fusible comprenant un cycle aromatique nitré, et préférentiellement du 2,4,6-trinitrotoluène ;
- ajout de modifiant de viscosité dans l'explosif fusible fondu, le modifiant de viscosité ayant une solubilité dans l'explosif fusible, supérieure à un seuil de solubilité au-dessus d'une température de seuil, et inférieure au seuil de solubilité au-dessous de la température de seuil, la température de seuil étant inférieure à une température de mélange et de chargement de la composition explosive, la viscosité de la composition étant inférieure à un seuil de viscosité au-dessus de la température de seuil et supérieure au seuil de viscosité au-dessous de de la température de seuil ; le modifiant de viscosité étant tel que pour une variation de température d'au plus 5°C en valeur absolue autour de la température de seuil, la variation correspondante de viscosité en valeur absolue est supérieure à 10 Pa.s fois la variation de température en valeur absolue, et la variation correspondante de solubilité en valeur absolue est supérieure à 15% massique.
- ajout d'au moins une espèce granulaire inerte et/ou au moins une espèce granulaire énergétique ;
les proportions des composants utilisés étant tels que la composition obtenue comprend 20 à 60% massique d'explosif fusible, et au plus 10% massique de modifiant de viscosité, et préférentiellement 3 à 5 % de modifiant de viscosité.

Dans un mode de mise en oeuvre, la température de seuil est comprise entre 85°C et 95°C, et la température de mélange et de chargement est supérieure à 95°C.

Selon un mode de mise en oeuvre, le modifiant de viscosité est un dérivé de benzène, ou de naphtalène, ou d'anthracène.

Dans un mode de mise en oeuvre, le modifiant de viscosité est du benzène, ou du naphtalène, ou de l'anthracène, fonctionnalisé par un ou plusieurs groupements parmi les groupements hydroxyles, carboxyles, ou sulfonyles.

Selon un mode de mise en oeuvre, le modifiant de viscosité est le naphtol, et préférentiellement le 1-naphtol ou le 2-naphtol.

Dans un mode de mise en oeuvre, une espèce granulaire inerte est de l'aluminium ou des sels de perchlorate.

Selon un mode de mise en oeuvre, une espèce granulaire énergétique est du RDX, de l'HMX, ou du TKX-50.

Dans un mode de mise en oeuvre, le procédé comprend, en outre, une étape de chargement (4) de la composition dans une munition délimitée par un corps creux, comprenant, une coulée de la composition explosive dans le corps creux d'une munition.

Selon un mode de mise en oeuvre, le procédé comprend, en outre, une étape de solidification lors du refroidissement de la composition à une température de la composition inférieure à la température de seuil entraînant une précipitation en masse de manière homogène et une augmentation de la viscosité du mélange, au-dessus du seuil de viscosité, piégeant instantanément les espèces granulaires.

L'invention sera mieux comprise à l'étude de quelques modes de réalisation décrits à titre d'exemples nullement limitatifs et illustrés par les dessins annexés sur lequel :
- la [Fig.1] illustre schématiquement la solubilité du modifiant de viscosité soluble dans le TNT et la viscosité du mélange, en fonction de la température de la composition, selon un aspect de l'invention ; et
- la [Fig.2] illustre schématiquement un exemple de procédé de fabrication d'une composition explosive fusible/coulable, selon un aspect de l'invention.

Sur l'ensemble des figures, les éléments ayant des références identiques sont similaires.

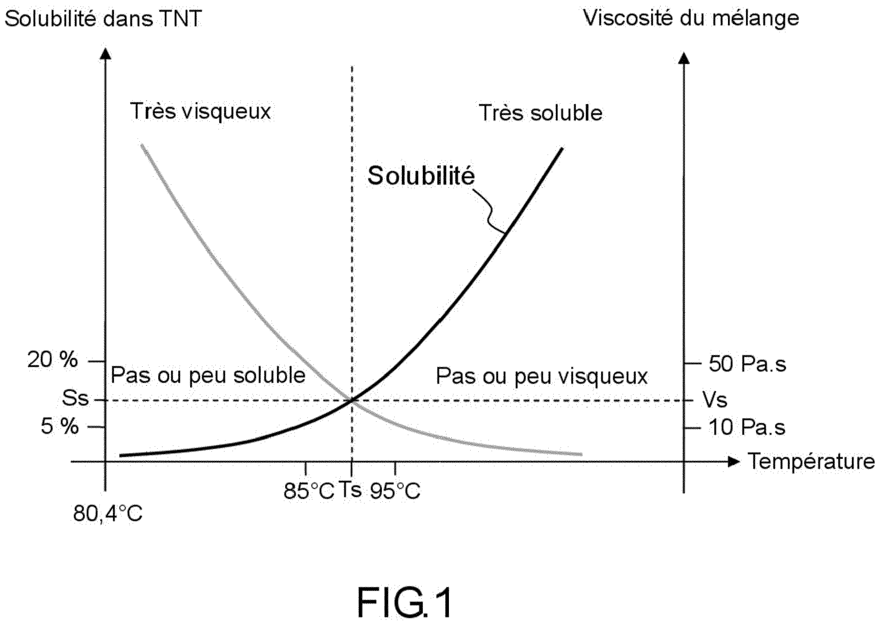

La [Fig.1] représente la solubilité du modifiant de viscosité soluble dans le TNT et la viscosité du mélange, en fonction de la température de la composition, selon un aspect de l'invention.

L'invention consiste notamment en l'utilisation d'un modifiant de viscosité dont la structure chimique possède de très fortes affinités chimiques avec un explosif fusible comprenant un cycle aromatique nitré, tel le 2,4,6-trinitrotoluène ou TNT.

Un explosif fusible comprenant un cycle aromatique nitré, tel le TNT présente de fortes interactions de Van der Waals dues au cycle benzénique et aux groupements Nitro en position 2 ,4 et 6. La présence de doublets non liants sur les oxygènes des groupements Nitro font que le TNT est également une forte base de Lewis. Pour assurer une miscibilité et donc une homogénéité maximale de la solution, la structure du modifiant de viscosité doit donc présenter de fortes interactions de Van der Waals et des fonctions acides de Lewis.

Aussi, la présente invention utilise un modifiant de viscosité ayant un profil de solubilité, fortement dépendant de la température, dans l'explosif fusible comprenant un cycle aromatique nitré, avec une température de seuil Ts telle qu'au-dessous de celle-ci le modifiant de viscosité est considéré comme pas ou peu soluble dans l'explosif fusible liquide comprenant un cycle aromatique nitré, i.e. la solubilité du modifiant de viscosité est inférieure à un seuil de solubilité Ss, et qu'au-dessus de celle-ci le modifiant de viscosité est considéré comme très soluble dans l'explosif fusible liquide comprenant un cycle aromatique nitré, i.e. la solubilité du modifiant de viscosité est supérieure au seuil de solubilité Ss.

En outre, au-dessus de la température de seuil Ts, la viscosité de la composition est considérée comme peu visqueuse, i.e. inférieure à un seuil de viscosité Vs, et au-dessous de la température de seuil Ts, la viscosité de la composition est considérée comme très visqueuse, i.e. supérieure au seuil de viscosité Vs.

La température de seuil Ts est inférieure à une température de mélange et de chargement de la composition explosive qui est généralement de l'ordre de 95°C.

Le modifiant de viscosité soluble dans l'explosif fusible comprenant un cycle aromatique nitré permet de piloter en fonction du besoin la viscosité du mélange.

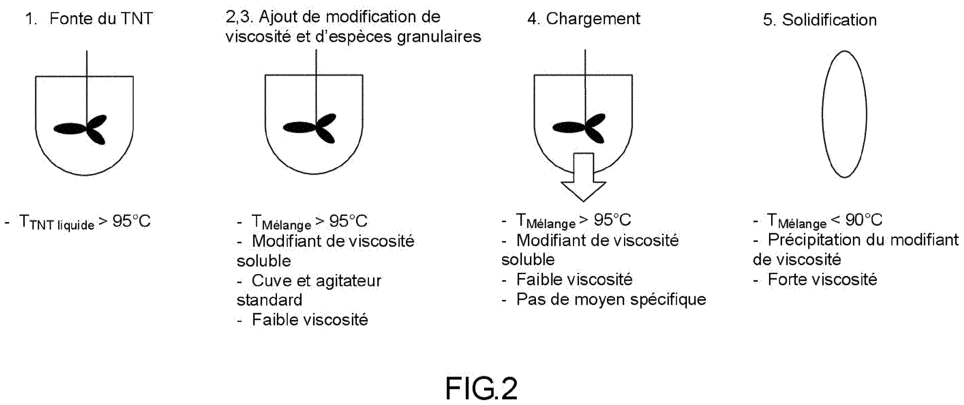

La [Fig.2] illustre schématiquement un exemple de procédé de fabrication d'une composition explosive fusible/coulable, selon un aspect de l'invention.

Le procédé de fabrication d'une composition explosive fusible/coulable comprend une première étape 1 de fonte (1) d'un explosif fusible comprenant un cycle aromatique nitré, préférentiellement du 2,4,6-trinitrotoluène ou TNT.

La fonte de l'explosif fusible comprenant un cycle aromatique nitré s'effectue à une température supérieure à 95°C.

Le procédé comprend une deuxième étape d'ajout 2 de modifiant de viscosité dans l'explosif fusible fondu. Le modifiant de viscosité possède une solubilité dans l'explosif fusible, supérieure à un seuil de solubilité Ss au-dessus de la température de seuil Ts, et inférieure au seuil de solubilité Ss au-dessous de la température de seuil Ts, la température de seuil étant inférieure à une température de mélange et de chargement de la composition explosive, généralement supérieur à 95°C. La viscosité de la composition est inférieure à un seuil de viscosité Vs au-dessus de la température de seuil Ts et supérieure au seuil de viscosité Vs au-dessous de de la température de seuil Ts.

Le modifiant de viscosité étant tel que pour une variation ΔT = Ts ± 5 °C de température d'au plus 5°C en valeur absolue autour de la température de seuil Ts, la variation correspondante de viscosité en valeur absolue est supérieure à 10 Pa.s, et la variation correspondante de solubilité en valeur absolue est supérieure à 15 % massique.

Cette étape 2 étant faite à une température de mélange et de chargement supérieure à 95°C, la composition a une faible viscosité et la solubilité du modifiant de viscosité est élevée.

Les proportions des composants utilisés étant tels que de la composition obtenue comprend 20 à 60% massique d'explosif fusible, et au plus 10% massique de modifiant de viscosité, et préférentiellement 3 à 5 % de modifiant de viscosité.

Ainsi, lors de l'étape 2, le modifiant de viscosité est très soluble dans l'explosif fusible comprenant un cycle aromatique nitré, tel le TNT, et la viscosité de la composition est considérée comme très peu ou peu visqueuse, i.e. inférieure au seuil de viscosité Vs.

L'utilisation d'un modifiant de viscosité à très forte affinité chimique avec l'explosif fusible comprenant un cycle aromatique nitré, tel le TNT, pour rendre ce dernier très soluble au-dessus de la température seuil Ts et très peu voire pas soluble au-dessous, permet d'activer la fonction du modifiant de viscosité en fonction de l'étape du procédé et du besoin par pilotage de la température du mélange.

Il est incorporé, pour toutes formulations à base d'explosif fusible comprenant un cycle aromatique nitré, tel le TNT, plusieurs espèces granulaires inertes et explosives. Ces compositions peuvent inclure ou non des espèces inertes comme de l'aluminium ou des sels de perchlorate à différents pourcentages massiques, ainsi que des espèces énergétiques telles que du RDX, de l'HMX ou du TKX-50 à différents taux.

Cela peut être réalisé par l'homme du métier sur du matériel standard connu, sans avoir à modifier les chaînes de production existantes.

En outre, la présente invention permet d'envisager de diminuer la fraction massique d'espèce fusible dans les formulations. Cela donne donc accès à des formulations jusqu'alors inaccessibles par le procédé de coulé-fondu et ouvre la possibilité d'éviter des procédés de mise en oeuvre plus complexes et plus chers (malaxage, extrusion)
Le modifiant de viscosité peut être du benzène, ou du naphtalène, ou de l'anthracène, fonctionnalisé par un ou plusieurs groupements parmi les groupements hydroxyles, carboxyles, ou sulfonyles.

Avantageusement, le modifiant de viscosité peut être du naphtol, et préférentiellement du 1-naphtol ou du 2-naphtol.

En outre, le procédé peut comprendre une étape de chargement 4 d'explosif d'une munition délimitée par un corps creux, comprenant, une coulée de la composition explosive dans le corps creux d'une munition.

Ainsi, la composition explosive fusible/coulable peut ensuite se solidifier lors d'une étape de solidification 5dans le corps de la munition, lors de son refroidissement. Après chargement le modifiant s'active par une précipitation en masse de manière uniforme augmentant ainsi drastiquement la viscosité et bloquant les mécanismes de sédimentation et de crémage. En effet, en fin de chargement, le mélange présent dans les munitions s'est refroidi et la température est inférieure à la température de seuil Ts. Le modifiant précipite en masse de manière homogène et entraîne une très forte augmentation de la viscosité du mélange, au-dessus du seuil de viscosité Vs. Les différentes espèces granulaires sont alors piégées quasi instantanément et les conditions de solidification sont fortement assouplies.

## Revendications

1. Procédé de fabrication d'une composition explosive fusible/coulable comprenant les étapes suivantes :
- fonte (1) d'un explosif fusible comprenant un cycle aromatique nitré, et préférentiellement du 2,4,6-trinitrotoluène ;
- ajout (2) de modifiant de viscosité dans l'explosif fusible fondu, le modifiant de viscosité ayant une solubilité dans l'explosif fusible, supérieure à un seuil de solubilité (Ss) au-dessus d'une température de seuil (Ts), et inférieure au seuil de solubilité (Ss) au-dessous de la température de seuil (Ts), la température de seuil (Ts) étant inférieure à une température (Tmc) de mélange et de chargement de la composition explosive, la viscosité de la composition étant inférieure à un seuil de viscosité (Vs) au-dessus de la température de seuil (Ts) et supérieure au seuil de viscosité (Vs) au-dessous de de la température de seuil (Ts) ; le modifiant de viscosité étant tel que pour une variation de température d'au plus 5°C en valeur absolue autour de la température de seuil, la variation correspondante de viscosité en valeur absolue est supérieure à 10 Pa.s fois la variation de température en valeur absolue, et la variation correspondante de solubilité en valeur absolue est supérieure à 15% massique.
- ajout (3) d'au moins une espèce granulaire inerte et/ou au moins une espèce granulaire énergétique ;
les proportions des composants utilisés étant tels que de la composition obtenue comprend 20 à 60% massique d'explosif fusible, et au plus 10% massique de modifiant de viscosité, et préférentiellement 3 à 5 % de modifiant de viscosité.

2. Procédé selon la revendication 1, dans lequel la température de seuil (Ts) est comprise entre 85°C et 95°C, et la température (Tmc) de mélange et de chargement est supérieure à 95°C.

3. Procédé selon la revendication 1 ou 2, dans lequel le modifiant de viscosité est un dérivé de benzène, ou de naphtalène, ou d'anthracène.

4. Procédé selon la revendication 3, dans lequel le modifiant de viscosité est du benzène, ou du naphtalène, ou de l'anthracène, fonctionnalisé par un ou plusieurs groupements parmi les groupements hydroxyles, carboxyles, ou sulfonyles.

5. Procédé selon l'une des revendications 3 ou 4, dans lequel le modifiant de viscosité est le naphtol, et préférentiellement le 1-naphtol ou le 2-naphtol.

6. Procédé selon l'une des revendications précédentes, dans lequel une espèce granulaire inerte est de l'aluminium ou des sels de perchlorate.

7. Procédé selon l'une des revendications précédentes, dans lequel une espèce granulaire énergétique est du RDX, de l'HMX, ou du TKX-50.

8. Procédé selon l'une des revendications précédentes, comprenant, en outre, une étape de chargement (4) de la composition dans une munition délimitée par un corps creux, comprenant, une coulée de la composition explosive dans le corps creux d'une munition.

9. Procédé selon l'une des revendications précédentes, comprenant, en outre, une étape de solidification (5) lors du refroidissement de la composition à une température de la composition inférieure à la température de seuil (Ts) entraînant une précipitation en masse de manière homogène et une augmentation de la viscosité du mélange, au-dessus du seuil de viscosité (Vs), piégeant instantanément les espèces granulaires.
